(19) Europäisches Patentamt
European Patent Office
Office européen des brevets

(11) **EP 4 782 920 A2**

(12) **EUROPEAN PATENT APPLICATION**

(43) Date of publication:
**29.07.2026 Bulletin 2026/31**

(21) Application number: **26185723.9**

(22) Date of filing: **17.06.2026**

(51) International Patent Classification (IPC):
*G03F 7/00* (2006.01)

(52) Cooperative Patent Classification (CPC):
**G03F 7/706837; G03F 7/706841**

(84) Designated Contracting States:
**AL AT BE BG CH CY CZ DE DK EE ES FI FR GB GR HR HU IE IS IT LI LT LU LV MC MD ME MK MT NL NO PL PT RO RS SE SI SK SM TR**
Designated Extension States:
**BA**
Designated Validation States:
**GE KH LA MA TN**

(71) Applicant: **ASML Netherlands B.V.**
**5500 AH Veldhoven (NL)**

(72) Inventors:
• **DE FREITAS KORBES, Greice**
**5500 AH Veldhoven (NL)**

• **VAN LUIJKEN, Mathieu Franciscus Andreas Cornelis**
**5500 AH Veldhoven (NL)**
• **KOK, Gijs**
**5500 AH Veldhoven (NL)**
• **BEINTEMA, Gerben, Izaak**
**5500 AH Veldhoven (NL)**
• **LOWET, Dietwig, Jos, Clement**
**5500 AH Veldhoven (NL)**
• **SUN, Wei**
**5500 AH Veldhoven (NL)**

(74) Representative: **ASML Netherlands B.V.**
**Corporate Intellectual Property**
**P.O. Box 324**
**5500 AH Veldhoven (NL)**

(54) **METROLOGY METHOD AND ASSOCIATED METROLOGY APPARATUS**

(57) Disclosed is a metrology method, comprising: obtaining metrology image data of a structure on a substrate, the metrology image data comprising images acquired at a substrate orientation using a metrology apparatus; obtaining image metadata corresponding to the metrology image data; obtaining a trained parameter of interest inference model, the trained parameter of interest inference model being operable to infer corrected parameter of interest data from images acquired at the substrate orientation and their corresponding image metadata, the corrected parameter of interest data being corrected for metrology apparatus asymmetry error; and using the trained parameter of interest inference model to infer the corrected parameter of interest data from the metrology image data and the corresponding image metadata.

Fig. 6

EP 4 782 920 A2

**Description**

FIELD OF THE INVENTION

The present invention relates to a metrology method such as may be performed for monitoring a lithographic process, and associated metrology apparatus.

BACKGROUND ART

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g., including part of, one, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. In lithographic processes, it is desirable frequently to make measurements of the structures created, e.g., for process control and verification. Various tools for making such measurements are known, including scanning electron microscopes, which are often used to measure critical dimension (CD), and specialized tools to measure overlay, a measure of the accuracy of alignment of two layers in a device. Overlay may be described in terms of the degree of misalignment between the two layers, for example reference to a measured overlay of 1 nm may describe a situation where two layers are misaligned by 1 nm.

Recently, various forms of scatterometers have been developed for use in the lithographic field. These devices direct a beam of radiation onto a target and measure one or more properties of the scattered radiation - e.g., intensity at a single angle of reflection as a function of wavelength; intensity at one or more wavelengths as a function of reflected angle; or polarization as a function of reflected angle - to obtain a "spectrum" from which a property of interest of the target can be determined. Determination of the property of interest may be performed by various techniques: e.g., reconstruction of the target by iterative approaches such as rigorous coupled wave analysis or finite element methods; library searches; and principal component analysis.

The targets used by conventional scatterometers are relatively large, e.g., gratings of 40μm by 40μm and the measurement beam generates a spot that is smaller than the grating (i.e., the grating is underfilled). This simplifies mathematical reconstruction of the target as it can be regarded as infinite. However, in order to reduce the size of the targets, e.g., to 10μm by 10μm or

less, e.g., so they can be positioned in amongst product features, rather than in the scribe lane, metrology has been proposed in which the grating is made smaller than the measurement spot (i.e., the grating is overfilled). Typically such targets are measured using dark-field scatterometry in which the zeroth order of diffraction (corresponding to a specular reflection) is blocked, and only higher orders processed. Examples of dark-field metrology can be found in international patent applications WO 2009/078708 and WO 2009/106279 which documents are hereby incorporated by reference in their entirety. Further developments of the technique have been described in patent publications US20110027704A, US20110043791A and US20120242970A. Modifications of the apparatus to improve throughput are described in US2010201963A1 and US2011102753A1. The contents of all these applications are also incorporated herein by reference. Diffraction-based overlay using dark-field detection of the diffraction orders enables overlay measurements on smaller targets. These targets can be smaller than the illumination spot and may be surrounded by product structures on a wafer. Targets can comprise multiple gratings which can be measured in one image.

In the known metrology technique, measurement results are obtained by measuring a metrology target to obtain the -1 and the +1 diffraction order intensities. The intensity asymmetry, a comparison of these diffraction order intensities, in the metrology target can be used as an indicator of the parameter of interest (e.g., overlay, dose or focus), where overlay describes an undesired misalignment of two layers, and focus and dose describe the focus and dose of the exposure when exposing the metrology target.

The acquired metrology images using techniques such as described, and parameters of interest derived therefrom, are subject to an error typically referred to as "tool-induced shift" (TIS). TIS is a measurement error arising from imperfections in the optical measuring tool. TIS can be caused, for example, when light from a light source is not exactly perpendicular to the substrate surface or is not telecentric.

It is desirable to improve on present methods for correcting for tool-induced shift (TIS) in metrology.

SUMMARY OF THE INVENTION

The invention in a first aspect provides a metrology method comprising: obtaining metrology image data of a structure on a substrate, the metrology image data comprising images acquired at a substrate orientation using a metrology apparatus; obtaining image metadata corresponding to the metrology image data; obtaining a trained parameter of interest inference model, the trained parameter of interest inference model being operable to infer corrected parameter of interest data from images acquired at the substrate orientation and their corresponding image metadata, the corrected parameter of interest data being corrected for metrology apparatus asymmetry error; and using the trained parameter of interest inference model to infer the corrected parameter of interest data from the metrology image data and the corresponding image metadata.

Further features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

BRIEF DESCRIPTION OF THE DRAWINGS

Embodiments of the invention will now be described, by way of example only, with reference to the accompanying drawings in which:

> Figure 1 depicts a lithographic apparatus according to an embodiment of the invention;
> Figure 2 depicts a lithographic cell or cluster according to an embodiment of the invention;
> Figure 3 comprises (a) a schematic diagram of an inspection apparatus usable in concepts disclosed herein, (b) a representation of a substrate and target in a first orientation, (c) a representation of the substrate and target in a second orientation, (d) a schematic illustration of the capture of a +1 diffraction order with a substrate in the first orientation, and (e) a schematic illustration of capture of a -1 diffraction order with the substrate in the second orientation;
> Figure 4 depicts a known form of a multiple grating target and an outline of a measurement spot on a substrate;
> Figure 5 depicts an image of the target of Figure 4 obtained in the inspection apparatus of Figure 3(a);
> Figure 6 depicts an exemplary trained parameter of interest inference model, and a process flow for inferring corrected parameter of interest data;
> Figure 7 depicts a cross-attention fusion module usable in the parameter of interest inference model of

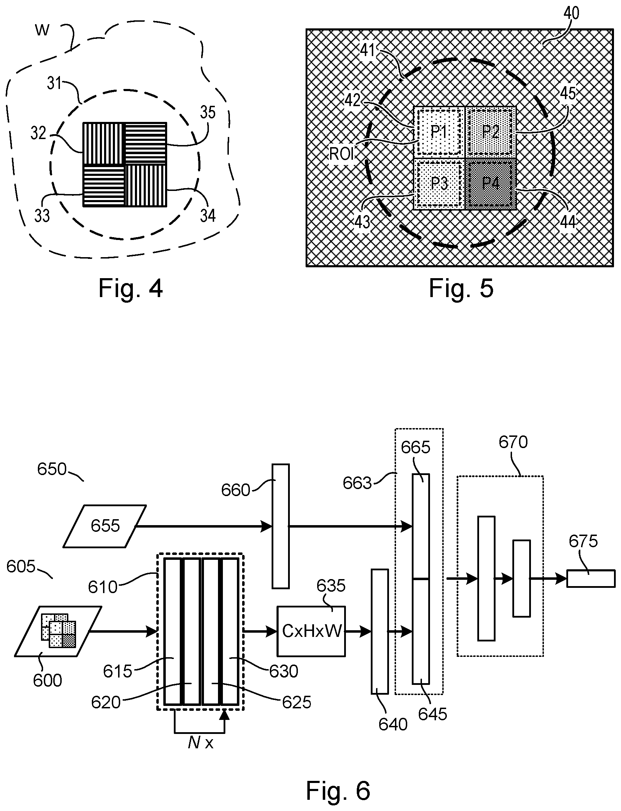

> Figure 6 for combining an image embedding and a metadata embedding; and

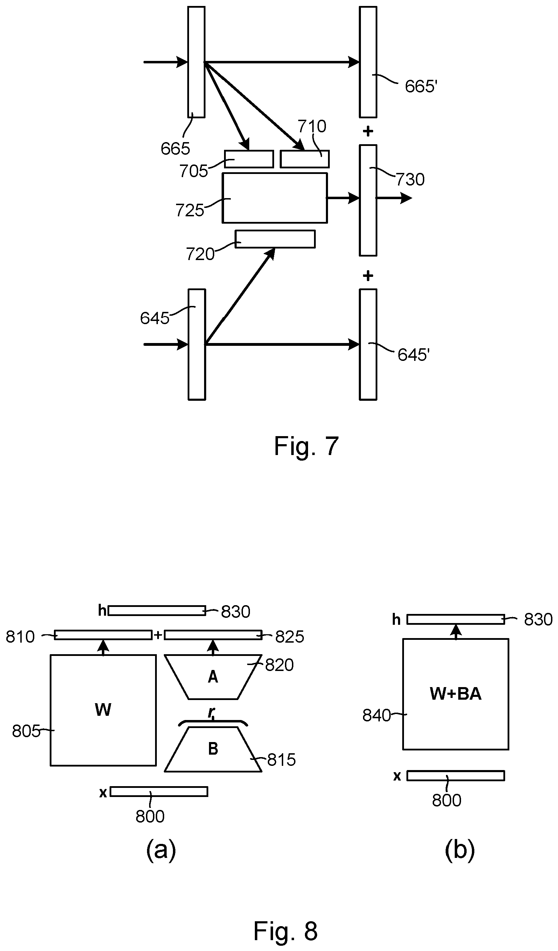

> Figure 8 depicts (a) the training and (b) the use of low-rank adapters (LoRA) to adapt the trained parameter of interest inference model of Figure 6 for different metrology apparatuses.

DETAILED DESCRIPTION OF EXEMPLARY EMBODIMENTS

Before describing embodiments of the invention in detail, it is instructive to present an example environment in which embodiments of the present invention may be implemented.

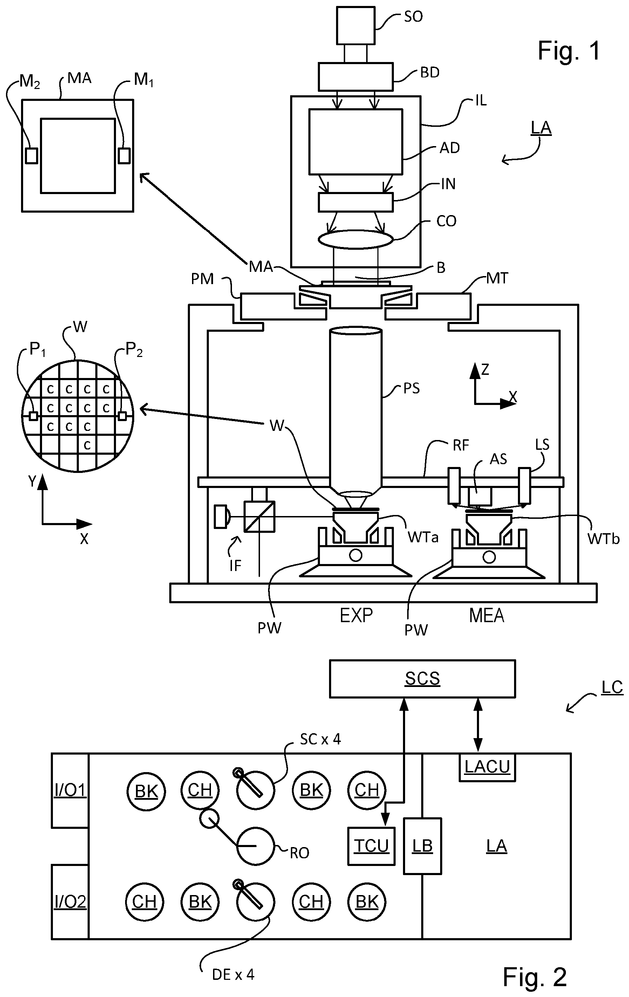

Figure 1 schematically depicts a lithographic apparatus LA. The apparatus includes an illumination optical system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; a substrate table (e.g., a wafer table) WTa, WTb constructed to hold a substrate (e.g., a resist coated wafer) W and connected to a second positioner PW configured to accurately position the substrate in accordance with certain parameters; and a projection optical system (e.g., a refractive projection lens system) PS configured to project a pattern imparted to the radiation beam B by patterning device MA onto a target portion C (e.g., including one or more dies) of the substrate W. In addition, the lithographic apparatus includes a reference frame RF.

The illumination optical system may include various types of optical or non-optical components, such as refractive, reflective, magnetic, electromagnetic, electrostatic or other types of components, or any combination thereof, for directing, shaping, or controlling radiation.

The patterning device support holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support may be a frame or a table, for example, which may be fixed or movable as required. The patterning device support may ensure that the patterning device is at a desired position, for example with respect to the projection system. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

The patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam, which is reflected by the mirror matrix.

As here depicted, the apparatus is of a transmissive type (e.g., employing a transmissive mask). Alternatively, the apparatus may be of a reflective type (e.g., employing a programmable mirror array of a type as referred to above, or employing a reflective mask).

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems. The term "immersion" as used herein does not mean that a structure, such as a substrate, must be submerged in liquid, but rather only means that liquid is located between the projection system and the substrate during exposure.

Referring to Figure 1, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may include an adjuster AD for adjusting the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may include various other components, such as an integrator IN and a condenser CO. The illuminator may be used to condition the radiation beam, to have a desired uniformity and intensity distribution in its cross section.

The radiation beam B is incident on the patterning device (e.g., mask) MA, which is held on the patterning device support (e.g., mask table MT), and is patterned by the patterning device. Having traversed the patterning device (e.g., mask) MA, the radiation beam B passes through the projection optical system PS, which focuses the beam onto a target portion C of the substrate W, thereby projecting an image of the pattern on the target portion C. With the aid of the second positioner PW and position sensor IF (e.g., an interferometric device, linear encoder, 2-D encoder or capacitive sensor), the substrate table WTa, WTb can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

Patterning device (e.g., mask) MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment markers may also be included within dies, in amongst the device features, in which case it is desirable that the markers be as small as possible and not require any different imaging or process conditions than adjacent features.

Lithographic apparatus LA in this example is of a so-called dual stage type which has two substrate tables WTa, WTb and two stations - an exposure station and a measurement station - between which the substrate tables can be exchanged. While one substrate on one substrate table is being exposed at the exposure station, another substrate can be loaded onto the other substrate table at the measurement station and various preparatory steps carried out. The preparatory steps may include mapping the surface control of the substrate using a level sensor LS and measuring the position of alignment markers on the substrate using an alignment sensor AS. This enables a substantial increase in the throughput of the apparatus.

The depicted apparatus can be used in a variety of modes, including for example a step mode or a scan mode. The construction and operation of lithographic apparatus is well known to those skilled in the art and need not be described further for an understanding of the present invention.

As shown in Figure 2, the lithographic apparatus LA forms part of a lithographic system, referred to as a lithographic cell LC or a lithocell or cluster. The lithographic cell LC may also include apparatus to perform pre- and post-exposure processes on a substrate. Conventionally these include spin coaters SC to deposit resist layers, developers DE to develop exposed resist, chill plates CH and bake plates BK. A substrate handler, or robot, RO picks up substrates from input/output ports I/O1, I/O2, moves them between the different process apparatus and delivers them to the loading bay LB of the lithographic apparatus. These devices, which are often collectively referred to as the track, are under the control of a track control unit TCU which is itself controlled by the supervisory control system SCS, which also controls the lithographic apparatus via lithography control unit LACU. Thus, the different apparatus can be operated to maximize throughput and processing efficiency.

In order that the substrates that are exposed by the lithographic apparatus are exposed correctly and consistently, it is desirable to inspect exposed substrates to measure properties such as overlay errors between subsequent layers, line thicknesses, critical dimensions (CD), etc. Accordingly a manufacturing facility in which lithocell LC is located also includes metrology system MET (not shown) which receives some or all of the substrates W that have been processed in the lithocell. Metrology results are provided directly or indirectly to the supervisory control system SCS. If errors are detected, adjustments may be made to exposures of subsequent substrates, especially if the inspection can be done soon and fast enough that other substrates of the same batch are still to be exposed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

Within metrology system MET, an inspection apparatus (or metrology apparatus) is used to determine the properties of the substrates, and in particular, how the properties of different substrates or different layers of the same substrate vary from layer to layer. The inspection apparatus (not shown) may be integrated into the lithographic apparatus LA or the lithocell LC or may be a stand-alone device. To enable most rapid measurements, it is desirable that the inspection apparatus measure properties in the exposed resist layer immediately after the exposure. However, the latent image in the resist has a very low contrast - there is only a very small difference in refractive index between the parts of the resist which have been exposed to radiation and those which have not - and not all inspection apparatuses have sufficient sensitivity to make useful measurements of the latent image. Therefore measurements may be taken after the post-exposure bake step (PEB) which is customarily the first step carried out on exposed substrates and increases the contrast between exposed and unexposed parts of the resist. At this stage, the image in the resist may be referred to as semi-latent. It is also possible to make measurements of the developed resist image - at which point either the exposed or unexposed parts of the resist have been removed - or after a pattern transfer step such as etching. The latter possibility limits the possibilities for rework of faulty substrates but may still provide useful information.

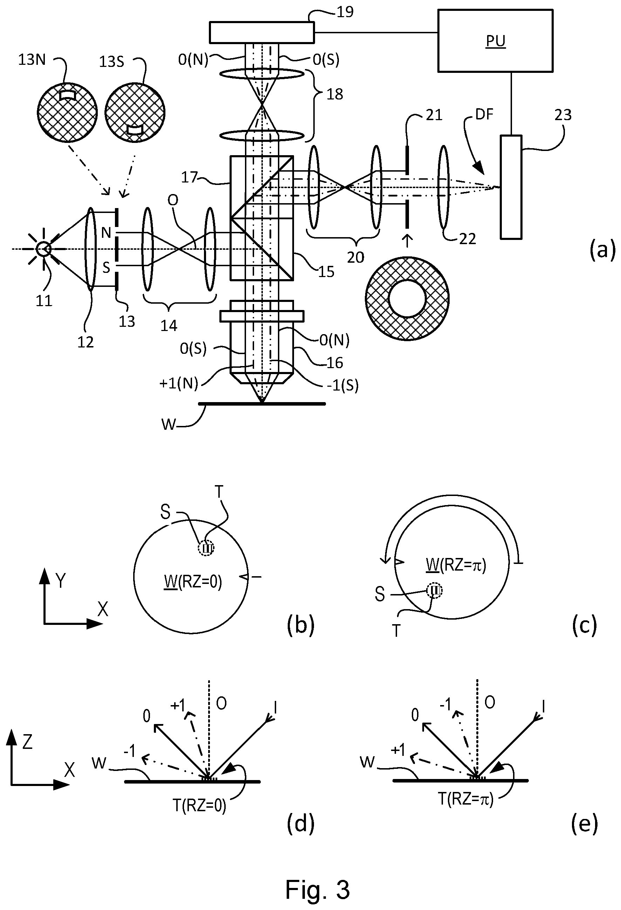

A metrology apparatus is shown in Figure 3(a). A target T and diffracted rays of measurement radiation used to illuminate the target are illustrated in more detail in Figures 3(b), 3(c), 3(d), 3(e). The metrology apparatus illustrated is of a type known as a dark-field metrology apparatus. The metrology apparatus depicted here is purely exemplary, to provide an explanation of dark-field metrology. The metrology apparatus may be a stand-alone device or incorporated in either the lithographic apparatus LA, e.g., at the measurement station, or the lithographic cell LC (as shown in Fig. 2). An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

In Figure 3(b), we see an example target T on a substrate W brought into measurement field S in a first orientation, which we can define by a rotation angle RZ of zero degrees (RZ=0). In Figure 3(c) we see the same target T brought into measurement field S with a rotation of 180 degrees (RZ=$\pi$ in radians). It will be understood that the sizes of measurement field and target here are greatly exaggerated for the sake of illustration. A real substrate may have many targets distributed across it, for measuring overlay and other parameters at different positions on the substrate. The diameter of measurement field S may be for example between 10 and 50 $\mu$m, while the target T fits within the measurement field diameter in this type of small target metrology. The target is thus referred to as "overfilled".

Figures 3(d) and 3(e) show schematically more detail of the diffraction spectrum that results when a periodic structure (grating) of target T is placed into measurement field S with substrate W normal to the optical axis O of objective lens 16, for the measurement examples of Figures 3(b) and 3(c) respectively. In Figure 3(d) the orientation RZ=0 is used, while in Figure 3(e) the 180 degree rotated orientation is used (RZ=$\pi$). In each case, target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). The two first order rays are reversed for each of the two wafer rotations. It should be remembered that with an overfilled small target, these rays are just one of many parallel rays covering the area of the substrate including metrology target T and other features. Since the aperture in plate 13 has a finite width (necessary to admit a useful quantity of light), the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 3(a), Figure 3(d) and Figure 3(e) are shown somewhat off axis, purely to enable them to be more easily distinguished in the diagram.

At least the 0 and +1/-1 orders diffracted by the target T on substrate W are collected by objective lens 16 and directed back through beam splitter 15. Returning to Figure 3(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled -1(S)) are the ones which enter the lens 16.

A second beam splitter 17 divides the diffracted beams into two measurement branches. In a first measurement branch, optical system 18 forms a diffraction spectrum (pupil plane image) of the target T on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented.

As such, the particular forms of aperture plate 13 and field stop 21 shown in Figure 3(a) are purely examples. In another embodiment of the invention, on-axis illumination of the targets is used and an aperture stop with an off-axis aperture is used to pass substantially only one first order of diffracted light to the sensor. In other examples, a two quadrant aperture may be used. This may enable simultaneous detection of plus and minus orders, as described in US2010201963A1, mentioned above. Embodiments with optical wedges (segmented prisms or other suitable elements) in the detection branch can be used to separate the orders for imaging spatially in a single image, as described in US2011102753A1, mentioned above. In yet other embodiments, 2nd, 3rd and higher order beams (not shown in Figure 3) can be used in measurements, instead of or in addition to the first order beams. In yet other embodiments, a segmented prism can be used in place of aperture stop 21, enabling both +1 and -1 orders to be captured simultaneously at spatially separate locations on image sensor 23.

Figure 4 depicts an overlay target or composite overlay target formed on a substrate according to known practice. The overlay target in this example comprises four sub-targets (e.g., gratings) 32 to 35 positioned closely together so that they will all be within a measurement spot 31 formed by the illumination beam of the metrology apparatus. The four sub-overlay targets thus are all simultaneously illuminated and simultaneously imaged on sensor 23. In an example dedicated to measurement of overlay, sub-targets 32 to 35 are themselves composite structures formed by overlying gratings that are patterned in different layers of the semiconductor device formed on substrate W. Sub-targets 32 to 35 may have differently biased overlay offsets in order to facilitate measurement of overlay between the layers in which the different parts of the composite sub-targets are formed. Sub-targets 32 to 35 may also differ in their orientation, as shown, so as to diffract incoming radiation in X and Y directions. In one example, sub-targets 32 and 34 are X-direction sub-targets with biases of the +d, -d, respectively. Sub-targets 33 and 35 are Y-direction sub-targets with offsets +d and -d respectively. Separate images of these sub-targets can be identified in the image captured by sensor 23. This is only one example of an overlay target. An overlay target may comprise more or fewer than 4 sub-targets.

Figure 5 shows an example of an image that may be formed on and detected by the sensor 23, using the overlay target of Figure 4 in the apparatus of Figure 3. While the pupil plane image sensor 19 cannot resolve the different individual sub-targets 32 to 35, the image sensor 23 can do so. The hatched area 40 represents the field of the image on the sensor, within which the illuminated spot 31 on the substrate is imaged into a corresponding circular area 41. Within this, rectangular areas 42-45 represent the images of the small overlay target sub-targets 32 to 35. If the overlay targets are located in product areas, product features may also be visible in the periphery of this image field. Image processor and controller PU processes these images using pattern recognition to identify the separate images 42 to 45 of sub-targets 32 to 35. In this way, the images do not have to be aligned very precisely at a specific location within the sensor frame, which greatly improves throughput of the measuring apparatus as a whole.

Once the separate images of the overlay sub-targets have been identified, the intensities of those individual images can be measured, e.g., by averaging or summing selected pixel intensity values within the identified areas, often referred as a region of interest (ROI). Intensities and/or other properties of the images can be compared with one another. These results can be combined to measure different parameters of the lithographic process. Overlay performance is an important example of such a parameter.

Using for example the method described in applications such as US20110027704A, mentioned above, overlay error (i.e., undesired and unintentional overlay misalignment) between the two layers within the sub-targets 32 to 35 is measured. Such a method may be referred to as micro diffraction based overlay (μDBO). This measurement may be done through overlay target asymmetry, as revealed by comparing their intensities in the +1 order and -1 order dark-field images (the intensities of other corresponding higher orders can instead be compared, e.g. +2 and -2 orders; however, the +1 and -1 orders will be assumed below) to obtain a measure of the intensity asymmetry. In its most basic implementation, the difference in the intensity of an image of the +1 diffraction order (conventionally referred to as the normal image) from a structure such as a metrology target and an image of the -1 diffraction order (conventionally referred to as the complementary image) from the structure can be mapped to an overlay value. As is well known, biased sub-targets as described above may be used to correct for the effect to target asymmetries unrelated to overlay.

The normal image and complementary image are separately imaged on a detector, and therefore the +1 and -1 diffraction orders will be carried via different detection paths, thereby encountering different aberrations and other error sources. This is one cause, amongst other causes, for an error referred to herein as tool-induced shift (TIS), or more generally as metrology apparatus asymmetry error. TIS contributes to the overall measurement uncertainty and directly impacts tool-to-tool matching and accuracy.

TIS is not only affected by the metrology sensor but also by stack and process. However, layers and products tend to have stable TIS from substrate to substrate and lot to lot.

To correct for tool-induced shift (TIS), a first known method of TIS correction is based on measuring each substrate twice at opposite orientations 180 degrees apart, often referred to as at wafer rotation of zero degrees WR0 and at wafer rotation of 180 degrees WR180. This is illustrated in Figures 3(b) to 3(e). It can be appreciated, with reference to Figures 3(d) and 3(e), that the +1 and -1 diffraction orders will swap detection paths for these two orientations. Therefore, a known method of correcting for tool-induced shift (TIS) in an overlay context may comprise averaging measurements over the two orientations; i.e.:

$$OV_{ACcorrected} = \frac{OV_{wr0} \mp OV_{wr180}}{2} \qquad [1]$$

where $OV_{ACcorrected}$ is overlay corrected for tool-induced shift (TIS) and $OV_{wr0}$, $OV_{wr180}$ is overlay measured at WR0 and WR180 respectively.

However, while this method is effective, it requires two measurements per substrate which is undesirable due to the throughput penalty incurred. To address this, a TIS correction calibration method has been used which balances the requirement for TIS correction and throughput. The present known method comprises performing a calibration in which a simple asymmetry correction model is fitted to (e.g., a small number of) measurements from the substrate in the two wafer orientations. In a production phase, the trained model is applied to estimate TIS on later substrates (measured at one rotation only) or, depending on the case, on other locations on the same substrate.

The concepts disclosed herein comprise extending this asymmetry correction model using deep-learning modules which combine multiple machine learning techniques, such as attention mechanisms, low-rank adaptation (LoRA) fine-tuning and other architectural enhancements, in a single unified approach. Such a method enables richer spatial feature extraction, allows lightweight adaptation of the trained model for different metrology apparatuses, and therefore provides a more flexible and generalizable model than any individual technique.

It is proposed herein to train and use a parameter of interest inference model comprising a combination of machine learning submodules, e.g., deep learning submodules, to predict parameter of interest data such as overlay from metrology images captured at a single orientation, the predicted overlay being corrected for TIS (i.e., metrology apparatus asymmetry error).

Figure 6 depicts an exemplary trained parameter of interest inference model, and a process flow for inferring corrected parameter of interest data (e.g. corrected overlay data) from metrology image data comprising measurement acquisitions of a single orientation. Metrology image data 600, which may comprise at least one pair of images (i.e., the normal and complementary image) is obtained at a single rotation (e.g., WR0). Such images may comprise normal or complementary darkfield images of a structure on a substrate, e.g., a metrology target such as an overlay or focus target. Metrology image data may further comprise only or in addition to the darkfield images, pupil plane images. The description will assume an overlay context, although the concepts disclosed are equally applicable to focus metrology (e.g., diffraction based focus DBF metrology), or any other parameter of interest which may be inferred from a difference/imbalance in normal and complementary images (diffraction order images) from a structure on a substrate. The machine learning modules of the parameter of interest inference model are assumed to have been trained for the inference method illustrated in Figure 6. A description of model training will be described later.

An image processing branch 605 processes the metrology image data 600 to obtain image embeddings 645. The imaging processing branch 605 may use one or more (e.g., N) convolutional neural networks 610. The number N of convolutional blocks may be between 1 and 10, between 2 and 8 or between 3 and 7. In a specific example, N=6. The convolutional blocks 610 comprise layers which are then flattened to obtain the image embedding 645. More specifically, each of the convolutional blocks may comprise a convolutional layer 615, a normalization layer 620, an activation layer 625 and a pooling layer 630.

Convolutional blocks comprising such a layer arrangement are well known in the field of image processing and will not be described in any great detail. Briefly, the convolutional layer performs feature extraction (e.g., to extract edges, shapes and textures) using filters (kernels) which are slid across the input with matrix multiplication being performed at each filter position to create "feature maps". This may be done using a number of different filters (of size $n$) to detect different features. Any number or size of filter may be employed. For example, the number of filters may be between 5 and 30 or between 10 and 20. In a specific example, the number of filters may be 16. The size $n$ of the filters may be between 3 and 10, between 3 and 8, or between 4 and 6. In a specific example, the filter is a 5x5 filter (i.e., $n$=5).

The normalization layer 620 normalizes the input layer by adjusting and scaling the activations (e.g., to have a mean of zero and a standard deviation of one). Good performance has been observed when the normalization layer employs group normalization (which computes the normalization statistics within each group of a number of small groups). Other normalization strategies may be used instead, such as batch normalization.

The activation layer 625 introduces non-linearity to the network. The activation function may comprise a Sigmoid Linear Unit (SiLU) activation function in a specific example, although other suitable activation functions may be employed by this layer, e.g.,: Rectified Linear Unit Gaussian (ReLU) or Error Linear Unit (GeLU).

The pooling layer 630 reduces the dimensionality (spatial size) of the feature maps, lowering computational cost and reducing overfitting. As such, the pooling layer provides for learned down sampling. In a specific example, this may be implemented as a further convolutional layer, e.g., with size 2x2 and stride 2 as a non-limiting specific example.

At least one image multilayer perceptron (MLP) 640 (comprising at least an input layer, one or more hidden layers and an output layer) classifies the high-level features 635 extracted by the convolutional and pooling layers to obtain the image embedding 645.

A second branch comprises a metadata branch 650 which encodes image metadata 655. The image metadata comprises a set of numerical values describing aspects of the images and their related acquisitions settings. As such, the image metadata 655 may comprise image performance indicator data and acquisition setting data. For example, image performance indicator data may comprise key performance indicators (KPIs) such as image intensities and/or uncorrected parameter of interest (e.g., overlay) values. Acquisition setting data may comprise one or more of: wavelength(s)/polarization(s) of the measurement radiation, illumination profile/aperture, detection aperture, position of the target on the substrate and/or within a measurement spot *etc.*. In a more specific example, the image metadata may comprise one or more of: numerical acquisition and context features including field and target position, on-wafer position, focus-related offsets, measurement direction, wavelength, bandwidth, aperture, dose, overlay-related values, diffraction-order intensity terms (normal/complementary and positive/negative), and derived intensity/asymmetry features. There may be over 10, over 20 or over 30 metadata features in total.

Metadata branch 650 may comprise (at least one) metadata multilayer perceptron 660 followed by (e.g., layer) normalization and (e.g., ReLU) activation layers to obtain a metadata embedding 665.

A fusion module 663 integrates the image embedding 645 and metadata embedding 665. The combined embedding is passed through an output head or prediction head 670 to provide a prediction 675 (i.e., a TIS corrected parameter of interest value). In a specific example the prediction head 670 may comprise a first linear layer followed by layer normalization and (e.g. SiLU) activation, and a second linear layer producing a scalar regression output.

Figure 7 illustrates the fusion module 663 in greater detail, which in this example is a cross-attention module. The image embedding 645 and metadata embedding 665 represent hidden states of the image and metadata, respectively, and are combined in the fusion module output to ensure that interaction is possible. This combination may be achieved via the cross-attention algorithm visualized in Figure 7. Here the metadata embedding 665 provides the key 705 and value 710, and the image embedding 645 is used as the query 720 using a (e.g., multi-headed) attention model (or attention layer) 725. It can be appreciated that this may be reversed and the metadata embedding 665 may be used as the query 720 and the image embedding 645 used as the key 705 and value 710. If query and key are reversed, the model will still run, particularly if the sequence length is selected to be 1 for the two branches (this is an optional implementation).

Optionally, the original image embedding 645' and metadata embedding 665' may also be concatenated to the resultant cross-attention 730 in the fusion module output. This creates a holistic vector representation of the image and metadata with interaction. The basic operation of attention mechanisms and multi-headed attention are well known and will not be described in further detail.

As such, by inputting single-rotation images 600 (e.g., normal and complementary diffraction-based overlay DBO/micro diffraction-based overlay µDBO or diffraction-based focus DBF/micro diffraction-based focus µDBF images) and their corresponding image metadata 655 (image metadata describing the context in which the images were acquired) into such the trained model, the model will yield a parameter of interest value 675 which has been corrected for metrology apparatus asymmetry error (i.e., TIS).

The model may be trained to predict the corrected parameter of interest value using training data comprising images, corresponding metadata and parameter of interest data (ground truth data) derived from images acquired at opposite orientations (e.g., in accordance with Equation [1] and its associated correction method described above). As such, the training data is derived from images acquired at both WR0 and WR180 and may comprise only the WR0 images or both the WR0 and WR180 images. The training images may be acquired at an image plane, a pupil plane and/or a combination of both. In either case, each image is labelled with a corresponding parameter of interest value derived from that image and its corresponding 180 degree rotated image (i.e., the target output is the parameter of interest value derived via Equation [1]). This has the advantage of training the model (e.g., using a supervised learning approach) to correct specifically for TIS, i.e., the error originating from differences in the normal and complementary branches of the sensor. However, other methods for obtaining ground truth values may be used instead, e.g., using scanning electron microscopy or similar high accuracy metrology to accurately measure overlay of the structures captured in the training images.

The training data may comprise training images corresponding to a variety of different metadata to learn the effect of metadata differences on the inferred parameter of interest.

The model is trained to predict the corrected parameter of interest value for any given training image and equivalent metadata with an aim to reduce or minimize the outlier errors. The cost function may comprise minimizing a Mean Squared Error (MSE) of the prediction $OV_{Pred}$ and the ground truth value $OV_{AC\ corrected}$ (see Equation [1]):

$$MSE = (OV_{AC\ corrected} - OV_{Pred})^2 \qquad [2]$$

The model may be optimized using an optimizer (e.g., AdamW optimizer) set at a learning rate (e.g., 0.0005) and a dropout and weight decay to diminish overfitting (e.g., 0.0 and 0.0003 respectively). To make learning smoother, a Learning Rate Scheduler may also be applied (e.g., Plateau). The specific examples and values recited are purely for example and are not in any way limiting.

Every metrology tool of a fab has its own lens aberrations and TIS response. Therefore, a unique model should be trained for each metrology tool. Fully training the model illustrated in Figure 6 and described above would be extremely onerous, as such a model may have multiple millions of parameters.

As such, to make the technique more useful in fab settings, the model may be augmented using low-rank adapters (LoRA) such that the core model may be trained once for one tool of a fab and adapted for other tools by training only low-rank adapters comprising far fewer parameters than the full model.

Figure 8 illustrates the concept of LoRA. The main idea behind LoRA is that the change in weights during model adaptation also has a low intrinsic rank/dimension. Figure 8(a) shows a training phase (adaptation phase) which trains low-rank matrices for adapting (specializing) a pretrained and fixed model 805. In normal training, the weights **W** of the model 805 are trained to minimize the difference between the input *x* 800 and target (truth) *h* 830 via the linear relationship *h*=**W***x*. In LoRA, the pretrained model 805 (weighted by matrix **W**) is fixed during the adaptation training. Instead, the weights **A, B** of two low-rank matrices 815, 820 (trainable rank decomposition matrices of rank *r*) are trained such that the combined output of the fixed pretrained model 805 and the low-rank matrices 815, 820 correspond to the target/truth *h*. As such, the training optimizes *h*=**W***x*+**AB***x,* with weights **AB** trained and weights **W** fixed. LoRA may be applied to all linear and convolutional layers in the model.

Referring to Figure 8(b), once the LoRA training is complete, the LoRA adaptation is used together with the pretrained model for estimation/inference. In one implementation, this may be realized by providing additive low-rank adapter modules which apply the low-rank update **AB** to the original pretrained (and fixed) weights **W** of the pretrained model 805. Other implementations (e.g., offline merge into a single stored weight matrix **W** +**AB**) are also possible; such methods are essentially and conceptually similar. The resultant adapted model 840 can then be used for estimation/inference. In essence, LoRA keeps the original model unchanged and adds small, changeable parts to each layer of the model.

By way of an example, the rank $r$ of the low-rank matrices may be between 1 and 7, between 2 and 6, between 3 and 5. In a specific example, $r$=4.

It is proposed to use this methodology to adapt a model trained on one metrology apparatus to infer the parameter of interest using images from other metrology apparatuses. This may be implemented individually for some or all layers and/or blocks of the model (e.g., as described by Figure 6), such as for one or more of the convolutional blocks 610, the metadata MLP 660 and/or the prediction head MLP layers 670.

In summary, unlike feature-based machine learning approaches, the methods disclosed here comprise inputting the entire metrology images directly into the machine-learning model. Using engineered or preprocessed features assumes that the image characteristics which contribute to TIS are known. In practice, this is not trivial and can vary significantly across tools, stacks, and use cases. By providing the full image directly to the model, the network can autonomously learn which spatial patterns and image characteristics are relevant for TIS correction, without being constrained by predefined assumptions. This also improves robustness and generalization to new use cases.

Convolutional blocks within the model autonomously extract spatial and intensity-related features relevant for TIS correction, without relying on pre-defined image kernels or deterministic feature extraction outside the machine learning pipeline. The learned image embeddings are subsequently fused with metadata embeddings derived from sensor configuration, recipe metadata, and other contextual information. A regression stage then directly outputs the corrected parameter of interest value.

Once trained, the system operates in production using WR0-only measurements. The trained model processes the single-orientation metrology image together with the associated metadata and sensor context to output a TIS-free parameter of interest value directly. This enables throughput equivalent to single-rotation acquisition while achieving overlay correction performance comparable to dual-rotation methods, with improved robustness and generalization across tools, stacks, and use cases.

The methods disclosed herein may be applicable to other overlay target types and overlay methods. One such method may comprise continuous diffraction-based overlay DBO (cDBO), which comprises measuring a target comprising sub-targets for which the gratings in each layer have different pitches. The order of the gratings are reversed in two complementary sub-targets (e.g., per direction); for example, a first-type sub-target may comprise the "M-type" sub-target which comprises the smaller pitch in the top layer and the second-type sub-target may comprise the "W-type" sub-target which comprises the larger pitch in the top layer.

The target arrangements illustrated and methods described have been those designed for measurement of overlay. However the concepts herein may also be applicable to target arrangements designed for measurement of another parameter of interest. For example, a focus arrangement (e.g., formed with regions having a focus sensitive asymmetry) can also benefit. Focus targets typically comprise features which have an asymmetry that has a (e.g., monotonic) relationship with scanner focus during their formation. This may be achieved, for example, by providing a grating or gratings with individual line features, where the line features each having sub-resolution features (assist features) along only one of its edges. These sub-resolution features cannot be exposed as they are too small, however their presence affects the formation of the edge of the line feature which depends on focus, thereby providing a focus dependent asymmetry. Therefore, by measuring intensity asymmetry from the target (e.g., in a similar manner to μDBO) the actual exposure focus during the target exposure can be inferred. Because of the similarity of the measurement strategy (intensity asymmetry, i.e., a comparison of the strength of +1 and -1 orders), and the fact that focus targets typically comprise two or more sub-targets (e.g., two sub-targets per measurement direction), the correction methods disclosed herein are equally applicable to DBF metrology.

An embodiment may include a computer program containing one or more sequences of machine-readable instructions describing methods of measuring targets on a substrate and/or analyzing measurements to obtain information about a lithographic process in accordance with the concepts disclosed herein. This computer program may be executed for example within unit PU in the apparatus of Figure 3(a) and/or the control unit LACU of Figure 2. There may also be provided a data storage medium (e.g., semiconductor memory, magnetic or optical disk) having such a computer program stored therein. Where an existing metrology apparatus, for example of the type shown in Figure 3(a), is already in production and/or in use, the invention can be implemented by the provision of updated computer program products for causing a processor to perform the steps necessary to calculate the overlay error.

The program may optionally be arranged to control the optical system, substrate support and the like to perform the steps necessary to calculate the overlay error for measurement of asymmetry on a suitable plurality of targets.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultraviolet (EUV) radiation (e.g., having a wavelength in the range of 5-20 nm), as well as particle beams, such as ion beams or electron beams.

The term "lens", where the context allows, may refer to any one or combination of various types of components, including refractive, reflective, magnetic, electromagnetic and electrostatic components.

The following numbered clauses describe examples of the concepts disclosed herein:

1. A metrology method, comprising:

    obtaining metrology image data of a structure on a substrate, the metrology image data comprising images acquired at a substrate orientation using a metrology apparatus;
    obtaining image metadata corresponding to the metrology image data;
    obtaining a trained parameter of interest inference model, the trained parameter of interest inference model being operable to infer corrected parameter of interest data from images acquired at the substrate orientation and their corresponding image metadata, the corrected parameter of interest data being corrected for metrology apparatus asymmetry error; and
    using the trained parameter of interest inference model to infer the corrected parameter of interest data from the metrology image data and the corresponding image metadata.

2. A method according to clause 1, wherein the trained parameter of interest inference model comprises an image processing branch for processing the metrology image data to obtain an image embedding and a metadata branch for processing the image metadata to obtain a metadata embedding.

3. A method according to clause 2, wherein the image processing branch comprises one or more convolutional blocks, each comprising at least a convolutional layer.

4. A method according to clause 3, wherein each of the one or more convolutional blocks further comprises an activation layer.

5. A method according to clause 4, wherein the activation layer applies a Sigmoid Linear Unit activation function.

6. A method according to clause 3, 4 or 5, wherein each of the one or more convolutional blocks further comprises a normalization layer and/or a pooling layer.

7. A method according to any of clauses 2 to 6, wherein the image processing branch comprises at least one image multilayer perceptron.

8. A method according to any of clauses 2 to 7, wherein the metadata branch comprises at least one metadata multilayer perceptron.

9. A method according to any of clauses 2 to 8, wherein the trained parameter of interest inference model comprises a fusion module being operable to combine the image embedding and metadata embedding to obtain a fusion module output.

10. A method according to clause 9, wherein the fusion module output comprises a cross-attention obtained by performing a cross-attention method using the metadata embedding as query and the image embedding as key and value, or using the image embedding as the query and the metadata embedding as the key and value.

11. A method according to clause 10, comprising concatenating the image embedding and metadata embedding to the cross-attention to obtain the fusion module output.

12. A method according to clause 9, 10 or 11, wherein the trained parameter of interest inference model comprises a prediction head which is operable to infer the corrected parameter of interest from the fusion module output.

13. A method according to any preceding clause, wherein the parameter of interest is overlay or focus.

14. A method according to any preceding clause, wherein the structure comprises at least a part of an overlay target or of a focus target.

15. A method according to any preceding clause, wherein the metrology image data comprises image data acquired at an image plane and/or at a pupil plane.

16. A method according to any preceding clause, wherein the metrology image data comprises images acquired at a substrate orientation of 0 or 180 degrees only.

17. A method according to any preceding clause, wherein the image metadata comprises image performance indicator data describing one or more performance indicators derived from the metrology image data and/or acquisition setting data describing one or more acquisition settings used to obtain the metrology image data.

18. A method according to any preceding clause, wherein the image metadata comprises one or more of acquisition parameters and measurement context features comprising field and target position, on-wafer position, focus-related offsets, measurement direction, wavelength, bandwidth, aperture, dose, overlay-related values, diffraction-order intensity terms (normal/complementary and positive/negative), and/or derived intensity/asymmetry features.

19. A method according to any preceding clause, comprising an adaptation step of adapting the trained parameter of interest inference model for the metrology apparatus, the metrology apparatus comprising a different metrology apparatus than the metrology apparatus for which the trained parameter of interest inference model was trained, the adaptation step comprising:

> obtaining training data from the metrology apparatus for which the model is to be adapted, the training data comprising training images, corresponding image metadata and corresponding ground truth values for the parameter of interest; using the training data to train low-rank matrices to improve the inferred corrected parameter of interest data of the trained parameter of interest inference model, such that the adapted trained parameter of interest inference model comprises the sum of weights of the trained parameter of interest inference model and of the trained weights of the low-rank matrices and/or additive low-rank adapter modules implementing the trained weights of the low-rank matrices in combination with the trained parameter of interest inference model.

20. A method according to any preceding clause, comprising an initial training step to train the parameter of interest inference model, the initial training step comprising:

> obtaining training data, the training data comprising training images, corresponding image metadata and corresponding ground truth values for the parameter of interest; using the training data to train the parameter of interest inference model to minimize a difference or mean-squared error between:
>
>> inferred parameter of interest data from images acquired at the substrate orientation; and
>> their corresponding ground truth values.

21. A method according to clause 19 or 20, wherein the training images comprise image data acquired at an image plane and/or at a pupil plane.

22. A method according to any of clauses 19 to 21, wherein the ground truth values comprise parameter of interest values derived from images obtained at two opposite substrate orientations.

23. A method according to clause 22, wherein the ground truth values comprise parameter of interest values corrected for metrology apparatus asymmetry error by averaging parameter of interest values from the images obtained at two opposite substrate orientations.

24. A method of training a parameter of interest inference model, the method comprising the steps of:

> obtaining training data, the training data comprising training images, corresponding image metadata and corresponding ground truth values for the parameter of interest; using the training data to train the parameter of interest inference model to minimize a difference or mean-squared error between:
>
>> inferred parameter of interest data from images acquired at the substrate orientation; and
>> their corresponding ground truth values.

25. A method according to clause 24, wherein the training images comprise image data acquired at an image plane and/or at a pupil plane.

26. A method according to any of clauses 24 to 25, wherein the ground truth values comprise parameter of interest values derived from images obtained at two opposite substrate orientations.

27. A method according to clause 26, wherein the ground truth values comprise parameter of interest values corrected for metrology apparatus asymmetry error by averaging parameter of interest values from the images obtained at two opposite substrate orientations.

28. A computer program comprising computer readable instructions for implementing the method of any of clauses 1 to 27, when run on a suitable apparatus.

29. A computer program comprising computer readable instructions which implement a trained parameter of interest inference model when run on a suitable apparatus, the trained parameter of interest inference model having been trained using the method of any of clause 19 to 27.

30. A non-transient computer program carrier comprising the computer program of clause 28 and/or 29.

31. A processing apparatus comprising:

> a processor; and
> the non-transitory computer program carrier of clause 30.

32. A metrology apparatus comprising the processing apparatus of clause 31.

33. A metrology system, comprising:
a metrology apparatus and a processing apparatus, the metrology apparatus comprising:

a substrate holder for holding a substrate;
projection optics for projecting illumination onto a substrate; and
a detector for detecting said scattered radiation at a detection plane to obtain metrology image data of a structure on a substrate, the metrology image data comprising images acquired at a substrate orientation and corresponding image metadata; and
the processing apparatus comprising a processor; and a non-transitory computer program carrier, the non-transient program carrier comprising a computer program comprising computer readable instructions which implement a trained parameter of interest inference model, the trained parameter of interest inference model having been trained to infer a corrected parameter of interest data from the metrology image data measured at a substrate orientation and corresponding image metadata obtained from the metrology apparatus.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims and their equivalents.

**Claims**

1. A metrology method, comprising:

obtaining metrology image data of a structure on a substrate, the metrology image data comprising images acquired at a substrate orientation using a metrology apparatus;
obtaining image metadata corresponding to the metrology image data;
obtaining a trained parameter of interest inference model, the trained parameter of interest inference model being operable to infer corrected parameter of interest data from images acquired at the substrate orientation and their corresponding image metadata, the corrected parameter of interest data being corrected for metrology apparatus asymmetry error; and
using the trained parameter of interest inference model to infer the corrected parameter of interest data from the metrology image data and the corresponding image metadata.

2. A method according to claim 1, wherein the trained parameter of interest inference model comprises an image processing branch for processing the metrology image data to obtain an image embedding and a metadata branch for processing the image metadata to obtain a metadata embedding.

3. A method according to claim 2, wherein the trained parameter of interest inference model comprises a fusion module being operable to combine the image embedding and metadata embedding to obtain a fusion module output.

4. A method according to claim 3, wherein the fusion module output comprises a cross-attention obtained by performing a cross-attention method using the metadata embedding as query and the image embedding as key and value, or using the image embedding as the query and the metadata embedding as the key and value.

5. A method according to claim 4, comprising concatenating the image embedding and metadata embedding to the cross-attention to obtain the fusion module output.

6. A method according to claim 3, 4, or 5, wherein the trained parameter of interest inference model comprises a prediction head which is operable to infer the corrected parameter of interest from the fusion module output.

7. A method according to any preceding claim, wherein the parameter of interest is overlay or focus.

8. A method according to any preceding claim, wherein the structure comprises at least a part of an overlay target or of a focus target.

9. A method according to any preceding claim, wherein the metrology image data comprises image data acquired at an image plane and/or at a pupil plane.

**10.** A method according to any preceding claim, wherein the metrology image data comprises images acquired at a substrate orientation of 0 or 180 degrees only.

**11.** A method according to any preceding claim, wherein the image metadata comprises image performance indicator data describing one or more performance indicators derived from the metrology image data and/or acquisition setting data describing one or more acquisition settings used to obtain the metrology image data.

**12.** A method according to any preceding claim, wherein the image metadata comprises one or more of acquisition parameters and measurement context features comprising field and target position, on-wafer position, focus-related offsets, measurement direction, wavelength, bandwidth, aperture, dose, overlay-related values, diffraction-order intensity terms (normal/complementary and positive/negative), and/or derived intensity/asymmetry features.

**13.** A method according to any preceding claim, comprising an initial training step to train the parameter of interest inference model, the initial training step comprising:

 obtaining training data, the training data comprising training images, corresponding image metadata and corresponding ground truth values for the parameter of interest;
 using the training data to train the parameter of interest inference model to minimize a difference or mean-squared error between:

  inferred parameter of interest data from images acquired at the substrate orientation; and
  their corresponding ground truth values.

**14.** A method according to claim 13, wherein the training images comprise image data acquired at an image plane and/or at a pupil plane.

**15.** A method according to any one of claims 13 and 14, wherein the ground truth values comprise parameter of interest values derived from images obtained at two opposite substrate orientations.

Fig. 1

Fig. 2

Fig. 3

Fig. 4

Fig. 5

Fig. 6

Fig. 7

(a)                                                (b)

Fig. 8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2009078708 A
- WO 2009106279 A
- US 20110027704 A
- US 20110043791 A
- US 20120242970 A
- US 2010201963 A1
- US 2011102753 A1